# EUROPÄISCHE PATENTSCHRIFT

(11) **EP 0 762 651 B1**
(45) Veröffentlichungstag und Bekanntmachung des Hinweises auf die Patenterteilung: **26.11.2003**
(21) Anmeldenummer: 96114335.1
(22) Anmeldetag: 06.09.1996
(51) Int. Cl.: H03K 17/0412

(54) **Treiberschaltung für eine Leuchtdiode**
Driver circuit for a light emitting diode
Circuit d'attaque pour une diode photoémettrice

(30) Priorität: 07.09.1995 DE 19533116
(43) Veröffentlichungstag der Anmeldung: 12.03.1997
(73) Patentinhaber: Infineon Technologies AG, 81669 München (DE)
(72) Erfinder: Wilhelm, Wilhelm, Dr. Ing., 81477 München (DE); Würtele, Johann, Dipl.-Ing., 80997 München (DE)
(74) Vertreter: Reinhard - Skuhra - Weise & Partner

(56) Entgegenhaltungen:
- EP-A- 0 441 965
- EP-A- 0 470 780
- EP-A- 0 542 480
- GB-A- 2 175 465
- US-A- 4 743 897

## Beschreibung

Die Erfindung betrifft eine Treiberschaltung für eine Leuchtdiode gemäss dem Oberbegriff des Anspruchs 1, wie aus der EP 0 441 965 A1 bekannt.

Zur Umsetzung von elektrischen in optische Signale werden entweder Laserdioden oder Leuchtdioden verwendet. Letztere zeichnen sich zwar durch größere Stabilität aus, doch sind sie deutlich Träger als Laserdioden. Um auch Leuchtdioden bei Datenraten von mehreren 100 Mbit/s betreiben zu können, müssen die Schaltströme beim Schaltvorgang überhöht angeboten werden. Dies gilt sowohl für den Einschaltvorgang als auch für den Abschaltvorgang. Beim Abschaltvorgang wird zu diesem Zweck die Diode mit umgekehrter Polarität angesteuert. Das bedeutet aber, daß durch die Leuchtdiode Strom in beiden Richtungen eingeprägt werden muß. Üblicherweise wird zum Umschalten der Stromrichtung bei fester Versorgungsspannung eine Brückenschaltung verwendet. Bei der Brückenschaltung sind jedoch zwei Schalter in Reihe zur Leuchtdiode notwendig. Setzt man für einen Schalter 0,9 Volt und für die Diode 2,2 Volt an, so ergibt sich, daß die Versorgungsspannung mindestens 4 Volt betragen muß. Jedoch stehen in vielen Fällen nur geringere Versorgungsspannungen zur Verfügung.

Aufgabe der Erfindung ist es, eine Treiberschaltung für eine Leuchtdiode anzugeben, bei der trotz geringerer Versorgungsspannung eine hohe Datenrate gewährleistet wird.

Die Erfindung wird durch eine Treiberschaltung gemäß Patentanspruch 1 gelöst.

Ausgestaltungen und Weiterbildungen des Erfindungsgedankens sind Gegenstand von Unteransprüchen.

Anstelle eines Umpolens der Leuchtdiode wird erfindungsgemäß vorgeschlagen, die Leuchtdiode niederohmig kurzzuschließen, um ein schnelles Entladen der in der Leuchtdiode gespeicherten Ladung zu bewirken. Damit liegt nur ein Schalter in Reihe zur Leuchtdiode, so daß der Spannungsabfall insgesamt geringer ist und demzufolge die Versorgungsspannung niedriger angesetzt werden kann.

Die die Leuchtdiode speisende Stromquellenschaltung weist nur einen einzigen Transistor in Reihe zur Leuchtdiode auf, mittels dessen je nach Ansteuerung drei verschiedene Stromstärken eingeprägt werden.

Die Erfindung wird nachfolgend anhand des in den Figuren der Zeichnung dargestellten Ausführungsbeispiels näher erläutert. Es zeigt:
- Figur 1: eine Ausführungsform einer erfindungsgemäßen Treiberschaltung in einem Schaltbild und
- Figur 2: den Verlauf verschiedener Signale bei dem Ausführungsbeispiel nach Figur 1 in einem Diagramm.

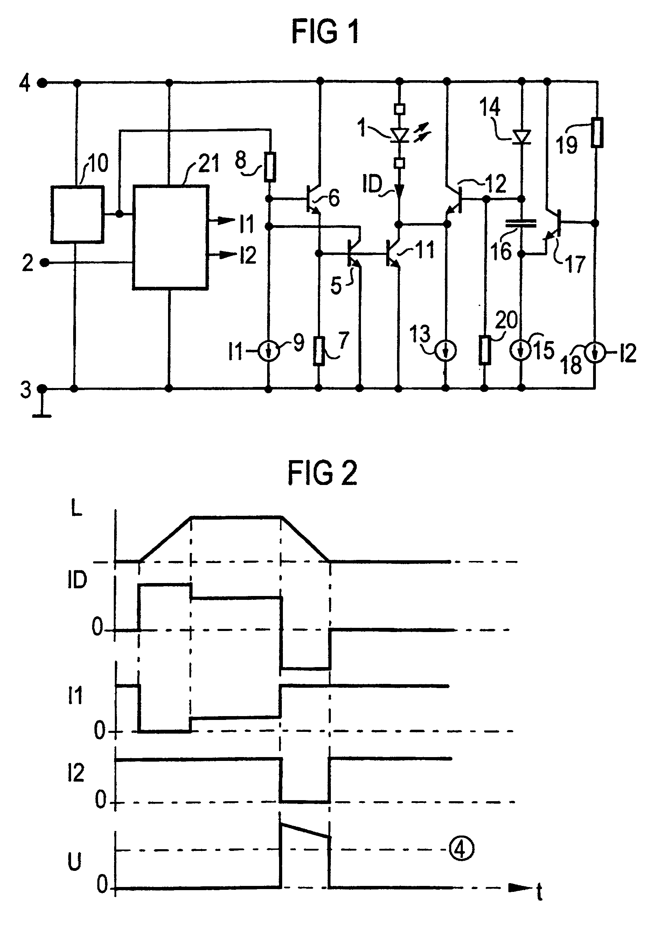

Bei der als Ausführungsbeispiel in Figur 1 gezeigten erfindungsgemäßen Treiberschaltung wird eine Leuchtdiode 1 entsprechend einem Eingangssignal 2 ein- und ausgeschaltet. Im Einzustand wird die Leuchtdiode 1 durch eine Stromquellenschaltung gespeist, während sie im Auszustand kurzgeschlossen wird. Im einfachsten Fall wird dazu ein Umschalter vorgesehen, der einen Anschluß der Leuchtdiode 1 im Einzustand mit einem Anschluß der über ihren anderen Anschluß mit dem anderen Anschluß der Leuchtdiode 1 verbundenen Stromquellenschaltung koppelt und im Auszustand den einen Anschluß der Leuchtdiode 1 mit deren anderen Anschluß koppelt. Durch das Kurzschließen der Leuchtdiode 1 im Auszustand wird ein Abfließen der in der Leuchtdiode 1 gespeicherten Ladung und damit ein schnelleres Ausschalten ermöglicht. Um auch ein schnelleres Einschalten der Leuchtdiode 1 zu erreichen, wird nach dem Übergang von dem Aus- auf den Einzustand zunächst ein stärkerer Strom und nach Ablauf einer gegebenen Zeitdauer ein geringerer Strom der Leuchtdiode 1 zugeführt.

Um eine weitere Reduzierung des Spannungsabfalls in Reihe zur Leuchtdiode 1 zu bewirken, wird bei der Erfindung der Umschalter in zwei einzelne Schalter aufgeteilt, von denen der eine zum Kurzschließen der Leuchtdiode 1 und der andere zum Aufschalten einer die Leuchtdiode 1 speisenden Stromquelle vorgesehen ist. Dabei werden der zum Aufschalten der die Leuchtdiode 1 speisenden Stromquelle vorgesehene Schalter sowie die Stromquelle selbst durch eine steuerbare Stromquellenanordnung ersetzt, bei der je nach Ansteuerung ein maximaler, ein mittlerer und ein minimaler Strom erzeugt werden können. Der minimale Strom kann dabei auch gleich Null sein.

Im einzelnen besteht die gesteuerte Stromquellenanordnung aus einem Transistor 11, dessen Laststrecke zu der Leuchtdiode 1 in Reihe geschaltet ist. Dazu ist ein Anschluß der Leuchtdiode 1 mit einem Versorgungspotential 4 und ihr anderer Anschluß mit dem Kollektor des Transistors 11 verbunden. Der Emitter des Transistors 11 ist ebenso wie der Emitter eines Transistors 5 mit einem Bezugspotential 3 verbunden, wobei die Basen der beiden Transistoren 11 und 5 miteinander sowie mit dem Emitter eines Transistors 6 und eines Anschlusses eines Widerstandes 7 verbunden sind. Der Widerstand 7 dient als Strombegrenzungselement und ist mit einem anderen Anschluß an das Bezugspotential 3 angeschlossen. Die Basis des Transistors 6, dessen Kollektor mit dem Versorgungspotential 4 verschaltet ist, steht mit einem Anschluß eines Widerstands 8, einem Anschluß einer steuerbaren Stromquelle 9 sowie mit dem Kollektor des Transistors 5 in Verbindung. Der andere Anschluß des Widerstands 8 ist mit einer Referenzspannungsquelle 10 gekoppelt, die zum Zwecke der Spannungsversorgung mit dem Versorgungspotential 4 und dem Bezugspotential 3 verbunden ist. Die Stromquelle 9, an deren anderen Anschluß das Bezugspotential 3 angelegt ist, wird durch eine Ansteuerschaltung 21 gesteuert, der neben dem Versorgungspotential und dem Bezugspotential 3 auch die von der Referenzspannungsquelle 10 erzeugte Referenzspannung sowie das Eingangssignal 2 zugeführt werden.

Bei der Erfindung wird also anstelle jeweils eines Transistors zum Schalten und zur Stromeinprägung nur ein Transistor 11 verwendet. Darüber hinaus ist der Transistor 11 anders als üblich ohne Strombegrenzungselemente im Emitterkreis emitterseitig direkt mit dem Bezugspotential 3 verbunden. Dadurch wird der Spannungsabfall zwischen der Leuchtdiode 1 und dem Bezugspotential 3 auf ein Minimum reduziert. Zur Kontrolle des Kollektorstroms des Transistors 11 wird der Kollektorstrom des parallel liegenden Transistors 5 überwacht, die zu diesem Zweck aufeinander abgestimmt sein sollten. Zur Vermeidung von zusätzlicher Verlustleistung wird die Emitterfläche des Transistors 5 wesentlich kleiner als die des Transistors 11 gewählt.

Eine andere Weiterbildung der Erfindung sieht vor, die Leuchtdiode 1 mittels eines Transistors 12 im Auszustand kurzzuschließen. Der Transistor 12 wird in Verbindung mit der Laststrecke des Transistors 11 als Emitterfolger derart betrieben, daß der Kollektor des Transistors 12 an das Versorgungspotential 4 angeschlossen ist und sein Emitter mit dem Kollektor des Transistors 11 verbunden ist. Für den Fall, daß der minimale Strom durch den Transistors 11 gleich Null ist, kann zusätzlich eine Konstantstromquelle 13 vorgesehen werden, die der Laststrecke des Transistors 11 parallel geschaltet ist. Diese ist in dem Fall für den Betrieb des Transistors 12 als Emitterfolger notwendig. Ein Entladen der Leuchtdiode 1 durch einen Emitterfolger als Schalter funktioniert aber nur dann mit genügend kleinem Spannungsabfall über dem Schalter, wenn die Basis des Emitterfolgertransistors über dessen Kollektorpotential hinaus angehoben wird. Zu diesem Zweck wird über eine Diode 14 und eine Konstantstromquelle 15 als Strombegrenzungselement ein Kondensator 16 während des Einzustandes aufgeladen. Die Diode ist dabei in Durchlaßrichtung einerseits an das Versorgungspotential 4 und andererseits an die Basis des Transistors 12 angeschlossen. Die Konstantstromquelle 15 ist einerseits mit dem Bezugspotential 3 und andererseits mit einem Anschluß des Kondensators 16 verbunden, dessen anderer Anschluß mit der Basis des Transistors 12 verschaltet ist. Zudem ist ein Transistor 17 vorgesehen, dessen Emitter an den Knotenpunkt zwischen Kondensator 16 und Konstantstromquelle 15 angeschlossen ist und an dessen Kollektor das Versorgungspotential 4 angelegt ist. Beim Einzustand der Leuchtdiode 1 ist der Transistor 17 gesperrt. Dagegen wird der Transistor 17 im Auszustand der Leuchtdiode 1 durchgeschaltet und damit der Knotenpunkt zwischen Kondensator 16 und Konstantstromquelle 15 annähernd an das Versorgungspotential 4 herangeführt. Aufgrund der Spannung über dem Kondensator 16 wird der Knotenpunkt zwischen dem Kondensator 16 und der Diode 14 und somit die Basis des Transistors 12 auf ein Potential angehoben, welches das Versorgungspotential 4 um die Spannung über dem Kondensator 16 übersteigt. Dadurch wird gewährleistet, daß der Transistor 12 vollkommen durchgeschaltet wird und sein Emitterpotential nahe an das Versorgungspotential 4 heranreicht. Somit wird die Leuchtdiode 1 bei kleinstmöglicher Impedanz entladen. Der Transistor 17 wird mittels einer steuerbaren Stromquelle 18 von der Ansteuerschaltung 21 gesteuert. Die Stromquelle 18 ist dazu zwischen die Basis des Transistors 17 und das Bezugspotential 3 geschaltet. Zudem ist ein Widerstand 19 zwischen die Basis des Transistors 17 und das Versorgungspotential 4 gesetzt zur Erzeugung einer Vorspannung an der Basis des Transistors 17. Schließlich ist ein Widerstand 20 zwischen die Basis des Transistors 12 und das Bezugspotential 3 geschaltet, der für eine definierte Eingangsimpedanz und damit einen definierten Entladewiderstand für den Kondensator 16 sorgt.

Beim vorliegenden Ausführungsbeispiel sind sämtliche Transistoren 3, 5, 6, 12, 17 Bipolartransistoren vom npn-Typ. Eine Realisierung ausschließlich aus Transistoren gleichen Typs ist insbesondere bei einer Ausführung der Treiberschaltung in integrierter Schaltungstechnik vorteilhaft. Die Verwendung von npn-Bipolartransistoren hat darüber hinaus den Vorteil, daß diese einen größeren Emitter-Kollektor-Strom zulassen und daher besser geeignet sind als pnp-Typen. Dennoch kann die Schaltung auch mit pnp-Bipolartransistoren sowie mit Feldeffekttransistoren realisiert werden. Aufgrund der Verwendung von npn-Bipolartransistoren ergibt sich für das Ausführungsbeispiel, daß das Versorgungspotential 4 positiv ist gegenüber dem Bezugspotential 3 und die Anoden der Leuchtdioden 1 und der Diode 14 demzufolge an das Versorgungspotential 4 angeschlossen sind.

Die steuerbaren Konstantstromquellen 9 und 18 werden von der Ansteuerschaltung 21 beispielsweise über jeweils einen Steuerstrom I1 und I2 in Abhängigkeit von dem Eingangssignal 2 gesteuert. Figur 2 der Zeichnung zeigt einen möglichen Verlauf der Steuerströme I1 und I2 über der Zeit t. Die durch die gesteuerten Stromquellen 9 und 18 erzeugten Ströme sind dabei zu dem jeweiligen Steuerstrom I1 bzw. I2 proportional. Danach hat der Steuerstrom I1 bis zu einem ersten Zeitpunkt einen maximalen Wert und danach bis zu einem zweiten Zeitpunkt einen minimalen Wert, der beim Ausführungsbeispiel gleich Null ist. Zwischen dem zweiten und einem dritten Zeitpunkt wird ein dazwischen liegender mittlerer Wert angenommen, um schließlich nach dem dritten Zeitpunkt erneut auf den Maximalwert überzugehen. Der Steuerstrom I2 ist dabei bis zum dritten Zeitpunkt auf einen bestimmten Wert ungleich Null gesetzt, von dem dritten Zeitpunkt bis zu einem vierten Zeitpunkt gleich Null und danach wieder gleich dem bestimmten Wert. Daraus resultiert für das Potential U an der Basis des Transistors 12 ein Verlauf, bei dem das Potential U bis zum dritten Zeitpunkt gleich Null ist, im dritten Zeitpunkt über das Versorgungspotential 4 hinaus steil ansteigt, anschließend bis zum vierten Zeitpunkt hin langsam abfällt, um dann steil auf Null abzufallen und dort zu verharren. Die langsam abfallende Flanke hängt dabei im wesentlichen von der Kapazität des Kondensators 16 sowie des Widerstandes 20 ab. Die Steilheit sowie die Dauer des langsamen Abfalls kann dabei beliebig gewählt werden, so lange ein vollständiges Entladen der in der Leuchtdiode 1 gespeicherten Ladung gewährleistet wird.

Für einen durch die Leuchtdiode 1 fließenden Strom ID ergibt sich infolgedessen ein Verlauf, bei dem der Strom ID bis zum ersten Zeitpunkt gleich Null ist, vom ersten bis zum zweiten Zeitpunkt gleich einem Maximalwert ist, vom zweiten bis zum dritten Zeitpunkt gleich einem mittleren Wert ist, vom dritten bis zum vierten Zeitpunkt gleich einem negativen Wert und schließlich nach dem vierten Zeitpunkt wieder gleich Null ist. Die von der Leuchtdiode 1 abgegebene Lichtleistung L ist zunächst gleich Null, steigt nach dem ersten Zeitpunkt bis zum zweiten Zeitpunkt auf einen Maximalwert an und hält diesen bis zum dritten Zeitpunkt. Danach fällt sie bis zum vierten Zeitpunkt wieder auf Null ab und bleibt auf Null. Einem derartigen Lichtimpuls liegt ein Ansteuersignal 2 zugrunde, das beispielsweise im ersten Zeitpunkt von einem logischen Zustand L auf einen logischen Zustand H wechselt, diesen bis zum dritten Zeitpunkt beibehält und danach wieder auf den logischen Zustand L zurückkippt. Mit der im Ausführungsbeispiel gezeigten Treiberschaltung ist ein ordnungsgemäßer Betrieb der Leuchtdiode bis zu einer minmalen Versorgungsspannung von 3,3 Volt bei derzeitig üblicher Technologie möglich.

## Patentansprüche

1. Treiberschaltung für eine Leuchtdiode (1) mit:
einer durch ein Eingangssignal (2) gesteuerten Schalteinrichtung (5 bis 20), mit der die Leuchtdiode (1) in Abhängigkeit von dem Eingangssignal (2) über einen ersten Transistor (11), dessen Laststrecke in Reihe zur Leuchtdiode (1) geschaltet ist, einschaltbar und über einen zweiten Transistor (12), dessen Laststrecke parallel zur Leuchtdiode (1) geschaltet ist, zum Ausschalten kurzschliessbar ist;
**dadurch gekennzeichnet, daß**
der Steueranschluß des ersten Transistors (11) über ein erstes Strombegrenzungselement (7) mit einem Bezugspotential (3) und über die Laststrecke eines dritten Transistors (6) mit einem Versorgungspotential (4) verbunden ist,
der Steueranschluß des dritten Transistors (6) über einen Widerstand (8) mit einem Referenzpotential und über eine erste steuerbare Stromquelle (9) mit dem Bezugspotential (3) verbunden ist,
zwischen den Steueranschluß des dritten Transistors (6) und das Bezugspotential (3) die Laststrecke eines vierten Transistors (5) geschaltet ist, dessen Steueranschluß mit dem Steueranschluß des ersten Transistors (11) verbunden ist, und
die erste steuerbare Stromquelle (9) zum Einschalten der Leuchtdiode von einer Ansteuereinrichtung (21) in Abhängigkeit von dem Eingangssignal (2) während einer ersten Schaltphase auf einen ersten Wert und während einer zweiten Schaltphase auf einen zweiten Wert, steuerbar ist, so daß während der ersten Schaltphase ein erster Strom und während der zweiten Schaltphase ein zweiter Strom durch die Leuchtdiode (1) fließt, wobei der zweite Strom geringer als der erste Strom ist.

2. Treiberschaltung nach Anspruch 1,
**dadurch gekennzeichnet, daß**
der zweite Transistor als Emitterfolger geschaltet ist;
der Steueranschluß des zweiten Transistors (12) über eine Diode (14) in Durchlaßrichtung mit dem Versorgungspotential (4) und über einen Kondensator (16) sowie einem nachfolgenden, in Reihe geschalteten ersten Konstantstromquelle (15) mit dem Bezugspotential (3) verbunden ist, und
zwischen das Versorgungspotential (4) und den Knotenpunkt von Kondensator (16) und erster Konstantstromquelle (15) die Laststrecke eines fünften Transistors (17) geschaltet ist, dessen Steueranschluss über eine zweite steuerbare Stromquelle (18) mit dem Bezugspotential (3) verbunden ist, und
die zweite steuerbare Stromquelle (18) zum Kurzschliessen der Leuchtdiode von der Ansteuereinrichtung (21) in Abhängigkeit von dem Eingangssignal (2) während einer dritten Schaltphase auf einen Wert steuerbar ist, so dass während der dritten Schaltphase der fünfte Transistor (17) durchgeschaltet ist und ansonsten gesperrt ist.

3. Treiberschaltung nach Anspruch 2,
**dadurch gekennzeichnet, daß**
der fünfte Transistor (17) in Verbindung mit der ersten Konstantstromquelle (15) in Emitterschaltung geschaltet ist.

4. Treiberschaltung nach Anspruch 2 oder 3,
**dadurch gekennzeichnet , daß**
der Laststrecke des ersten Transistors (11) eine zweite Konstantstromquelle (13) parallelgeschaltet ist.

5. Treiberschaltung nach einem der Ansprüche 2 bis 4,
**dadurch gekennzeichnet, daß** sämtliche Transistoren (5, 6, 11, 12, 17) vom gleichen Leitungstyp sind.

## Claims

1. Driver circuit for a light-emitting diode (1) having:
a switching device (5 to 20) controlled by an input signal (2), by means of which switching device the light-emitting diode (1), depending on the input signal (2), can be switched on via a first transistor (11), whose load path is connected in series with the light-emitting diode (1), and can be short-circuited via a second transistor (12), whose load path is connected in parallel with the light-emitting diode (1), for the purpose of switch-off;
**characterized in that**
the control terminal of the first transistor (11) is connected to a reference-earth potential (3) via a first current limiting element (7) and to a supply potential (4) via the load path of a third transistor (6),
the control terminal of the third transistor (6) is connected to a reference potential via a resistor (8) and to the reference-earth potential (3) via a first controllable current source (9),
the load path of a fourth transistor (5) is connected between the control terminal of the third transistor (6) and the reference-earth potential (3), the control terminal of which fourth transistor is connected to the control terminal of the first transistor (11), and
the first controllable current source (9), for the purpose of switching on the light-emitting diode, can be controlled by a drive device (21), depending on the input signal (2), to a first value during a first switching phase and to a second value during a second switching phase, so that a first current flows through the light-emitting diode (1) during the first switching phase and a second current flows through the light-emitting diode (1) during the second switching phase, the second current being less than the first current.

2. Drive circuit according to Claim 1,
**characterized in that**
the second transistor is connected as an emitter follower;
the control terminal of the second transistor (12) is connected to the supply potential (4) via a diode (14) in the forward direction and to the reference-earth potential (3) via a capacitor (16) and also a downstream first constant-current source (15) connected in series, and
the load path of a fifth transistor (17) is connected between the supply potential (4) and the node of capacitor (16) and first constant-current source (15), the control terminal of which fifth transistor is connected to the reference-earth potential (3) via a second controllable current source (18), and
the second controllable current source (18), for the purpose of short-circuiting the light-emitting diode, can be controlled by the drive device (21), depending on the input signal (2), to a value during a third switching phase, so that the fifth transistor (17) is turned on during the third switching phase and is otherwise turned off.

3. Driver circuit according to Claim 2,
**characterized in that**
the fifth transistor (17) is connected to the first constant-current source (15) in a common-emitter connection.

4. Driver circuit according to Claim 2 or 3,
**characterized in that**
a second constant-current source (13) is connected in parallel with the load path of the first transistor (11).

5. Driver circuit according to one of Claims 2 to 4,
**characterized in that**
all the transistors (5, 6, 11, 12, 17) are of the same conduction type.

## Revendications

1. Circuit d'attaque pour une diode photoémettrice (1) avec
un dispositif de commutation (5 à 20) commandé par un signal d'entrée (2), avec lequel la diode photoémettrice (1) est commutée en fonction du signal d'entrée (2) au moyen d'un premier transistor (11), dont le circuit de charge est monté en parallèle avec la diode photoémettrice (1), et peut être court-circuité pour la déconnexion au moyen d'un second transistor (12), dont le circuit de charge est branché parallèlement à la diode photoémettrice (1) ;
**caractérisé en ce que**
la borne de commande du premier transistor (11) est reliée au moyen d'un élément de limitation de courant (7) à un potentiel de référence (3) et au moyen du circuit de charge d'un troisième transistor (6) à un potentiel d'alimentation (4),
la borne de commande du troisième transistor (6) est relié au moyen d'une résistance (8) à un potentiel de référence et au moyen d'une première source de courant (9) commandable au potentiel de référence (3),
entre la borne de commande du troisième transistor (6) et le potentiel de référence (3) est monté le circuit de charge d'un quatrième transistor (5), dont la borne de commande est reliée à la borne de commande du premier transistor (11), et
la première source de courant (9) commandable pour la mise en route de la diode photoémettrice peut être commandée par un dispositif de commande (21) en fonction du signal d'entrée (2) pendant une première phase de commutation sur une première valeur et pendant une seconde phase de commutation sur une seconde valeur, de sorte qu'un premier courant et un second courant circulent dans la diode photoémettrice (1) respectivement pendant la première phase de commutation et la seconde phase de commutation, le second courant étant donc plus faible que le premier courant.

2. Circuit d'attaque selon la revendication 1,
**caractérisé en ce que**
le second transistor est branché comme émetteur-suiveur ;
le branchement de commande du second transistor (12) est relié au moyen d'une diode (14) dans le sens passant au potentiel d'alimentation (4) et au moyen d'un condensateur (16) et d'une première source de courant constant (15) consécutive et branchée en série au potentiel de référence (3), et
entre le potentiel d'alimentation (4) et le noeud du condensateur (16) et de la première source de courant constant (15) est monté le circuit de charge d'un cinquième transistor (17), dont le branchement de commande est relié par une seconde source de courant (18) commandable au potentiel de référence (3), et
la seconde source du courant (18) commandable pour le court-circuitage de la diode photoémettrice peut être contrôlée par le dispositif d'amorçage (21) en fonction du signal d'entrée (2) pendant une troisième phase de commutation sur une valeur, de sorte que le cinquième transistor (17) est passant pendant la troisième phase de commutation et bloqué sinon.

3. Circuit d'attaque selon la revendication 2,
**caractérisé en ce que**
le cinquième transistor (17) est branché dans le circuit émetteur en liaison avec la première source de courant constant (15).

4. Circuit d'attaque selon la revendication 2 ou 3,
**caractérisé en ce qu'**une seconde source de courant constant (13) est branchée en parallèle avec le circuit de charge du premier transistor (11).

5. Circuit d'attaque selon l'une quelconque des revendications 2 à 4,
**caractérisé en ce que** tous les transistors (5, 6, 11, 12, 17) sont du même type de conduction.
